# EUROPEAN PATENT SPECIFICATION

(11) **EP 3 486 813 B1**
(45) Date of publication and mention of the grant of the patent: **27.04.2022**
(21) Application number: 18206393.3
(22) Date of filing: 15.11.2018
(51) Int. Cl.: G06F 30/15

(54) **MANUFACTURING AND ASSEMBLY METHOD AND SYSTEM OF PARTS OF AN AIRCRAFT**
HERSTELLUNGS- UND MONTAGEVERFAHREN UND SYSTEM VON TEILEN EINES FLUGZEUGS
PROCÉDÉ ET SYSTÈME DE FABRICATION ET D'ASSEMBLAGE DE PARTIES D'UN AÉRONEF

(30) Priority: 17.11.2017 ES 201731337
(43) Date of publication of application: 22.05.2019
(73) Proprietor: Airbus Defence and Space SAU, 28906 Getafe (ES)
(72) Inventor: ESTEBAN FINCK, Fernando, 28906 Getafe (ES); JIMÉNEZ DURÁN, Francisco Javier, 28906 Getafe (ES); LEÓN ARÉVALO, Francisco José, 28906 Getafe (ES); RODRÍGUEZ GARRIGÓS, Francisco, 28906 Getafe (ES); GRANERO MONTAGUD, Luis, 28906 Getafe (ES)
(74) Representative: Elzaburu S.L.P.

(56) References cited:
- A. GÓMEZ ET AL: "Development based on reverse engineering to manufacture aircraft custom-made parts", INTERNATIONAL JOURNAL OF MECHATRONICS AND MANUFACTURING SYSTEMS, vol. 10, no. 1, 8 June 2017 (2017-06-08), pages 40-58, XP055577577, ISSN: 1753-1039, DOI: 10.1504/IJMMS.2017.084406

## Description

### Field of the invention

The present invention relates to a manufacturing and assembly method and system of parts of an aircraft with fast manufacturing and reducing the need of jigs for performing the manufacturing and assembly operations.

### Background of the invention

In the aeronautic industry the assembly of parts in big structures with small tolerances is very common, for instance, it is performed in spinning axis in horizontal stabilizers, wings or fuselages.

Currently, in order to assemble these parts, jigs or tooling with big stable welded structures are used, mounted and assembled with an exterior verification system, as a laser tracker, micro-alignment telescopes, transit or theodolites. In some cases photogrammetry, articulated arms, laser radars or portable optic measurement systems. On these structures the part to be assembled is positioned in the required position.

These jigs require foundations with strong requirements in order to avoid undesired movements of the metallic structure of the jig and constant verifications to ensure that the structure has not moved from its initial state. In general, the positioning of aircraft parts is carried out with tooling auxiliary parts attached to the jigs and positioned with an external positioning system, for instance, fittings attached to the jig that position aircraft axis in the appropriate position.

All these resources needed for the manufacturing correspond to the 10% of the global cost of an aeronautical structure. The costs are divided in Non-Recurrent Costs (NRC), the initial investment, and Recurrent Costs (RC). Jigs and tooling costs are mainly a part of the NRC. Estimations show that more than a third of the NRC of an aircraft manufacturing is due to jigs and tooling. This fact represents an enormous capital investment, with long return periods. More problems associated with the use of big structures with "hard points" of reference or, what is the same, points that require periodic verification are:
- Jigs are specifically manufactured for a specific program and without the possibility of being reused in another program. When a program finishes it is impossible to reuse the jig as it is not possible to adapt it to a new program.
- Jigs need recalibration in order to ensure its exactness. This periodical operation (usually once or twice a year) is expensive, complicated and require long periods of inactivity.
- The difference between aircraft and jig materials create problems regarding assembly and measurement due to thermal dilatations.

Prior art document XP055577577 titled "Development based on reverse engineering to manufacture aircraft custom-made parts" discloses a method for building a file with 3D point cloud data in order to manufacture aircraft custom-made parts.

### Summary of the invention

The manufacturing and assembly method and system object of the invention modifies the traditional assembly processes. Due to new measurement, design and manufacturing processes, the assembly of parts can be done with great precision without conventional jigs, reducing design, manufacturing, assembly and maintenance costs. The no necessity of conventional jigs implies not only time and cost savings in the design, manufacturing and maintenance of the parts, but also the disappearance of the lack of flexibility of traditional methods.

The manufacturing and assembly method object of the invention comprises the following steps:
- providing a first aircraft part comprising at least a receptor surface on which a coupling surface of a second aircraft part is to be assembled,
- providing in a computer program a model of the first and the second aircraft parts located in its assembled position, the model of the second aircraft part comprising machining allowances in its coupling surface,
- digitalising by a digitalising system the receptor surface of the first aircraft part obtaining a digitalised surface, for instance, formed by a cloud of points,
- positioning the digitalisation of the receptor surface in the computer model of the first and the second aircraft parts in the assembled position such that the digitalisation of the receptor surface intersects the machining allowances of the coupling surface of the second aircraft part,
- obtaining in the computer model a computer designed model of the second aircraft part in which the coupling surface of the second aircraft part adapted to be assembled on the receptor surface of the first aircraft part fits to the digitalised receptor surface,
- mechanising the second aircraft part to be assembled from the above obtained computer model,
- assembling the mechanised second aircraft part to the provided first aircraft part.

Therefore, the key steps of the claimed manufacturing and assembly method are: starting with a receptor surface that may be located in an unknown position, digitising said receptor surface, positioning said digitalisation in a computer designed theoretical model of the first and the second aircraft parts, for instance a CAD model, in its real assembled position wherein the coupling surface of the second aircraft part comprises machining allowances, i.e., it is oversized with respect to its nominal size. The digitalisation of the receptor surface therefore intersects the machining allowances of the coupling surface of the second aircraft part and the coupling surface of the second aircraft part is achieved by obtaining a surface that fits the cloud of points, i.e., the digitised receptor surface in the computer theoretical model. For instance, with reverse engineering it will be obtained a CAD reconstruction of the real part of the second aircraft part which adapts to the receptor surface.

The obtained CAD model of the second aircraft part comprises therefore a coupling surface that is a copy of the receptor surface of the first part and thus implying that the adjustment between both elements may have minimal deviations. Said advantage avoids the need to employ liquids or solids applications between both surfaces in the assembly process. The tailored manufacturing of the second aircraft part allows its perfect adjustment with the receptor surface of the first aircraft part fulfilling the established tolerances. This in turn involves the removal of shim element, both solid and liquid at the interfaces of both parts. The CAD model will be afterwards exported to a proper format for mechanisation of the second aircraft part.

The first aircraft part may be positioned in a stable element, with a known position not being necessary. The main advantage over the known methods is that the element where the first and second parts are to be placed does not require precise positioning in a conventional jig. This jig element could be replaced thanks to the claimed invention by a support structure of smaller mechanical restrictions involving cost reduction, maintenance, etc, in the embodiments in which said support structure is advisable.

Therefore, the claimed method comprises a set of operations and measurements that will provide as a result the manufacturing, positioning and assembly of a part, for instance, fitting, axis...in its assembly position meeting tolerance requirements.

It is also an object of said invention a manufacturing and assembly system comprising:
- a computer program model of a first and a second aircraft parts configured to be located in its assembled positions, the first aircraft part configured to have at least a receptor surface on which a coupling surface of the second aircraft part is to be assembled and the model of the second aircraft part comprising machining allowances in its coupling surface,
- a digitalising system configured to digitalise the receptor surface of the first aircraft part, for instance, obtaining a cloud of points,
   ∘ the computer program model being configured to position the digitalisation of the receptor surface in the assembled position such that the digitalisation of the receptor surface intersects the machining allowances of the coupling surface of the second aircraft part,
   ∘ the computer program model being also configured to obtain a computer designed model of the second aircraft part in which the coupling surface of the second aircraft part adapted to be assembled on the receptor surface of the first aircraft part is configured to fit the digitalised receptor surface,
- a mechanising system configured to mechanised the obtained computer designed model of the second aircraft part.

Summarising, the claimed system and method provides the following advantages:
- Reduction of costs in jigs.
- Reduction of manufacturing times.
- Elimination or drastic reduction of the use of shims liquids or solids.
- Reduction of maintenance of jigs.
- Custom manufacture of components with detailed analysis of each one and dimensional traceability.

### Brief description of the drawings

To complete the description and in order to provide for a better understanding of the invention, a set of drawings is provided. Said drawings form an integral part of the description and illustrate preferred embodiments of the invention. The drawings comprise the following figures.
Figure 1 shows a perspective view of an embodiment of an assembled first and a second aircraft structure, being the first aircraft structure mounted on a support structure.

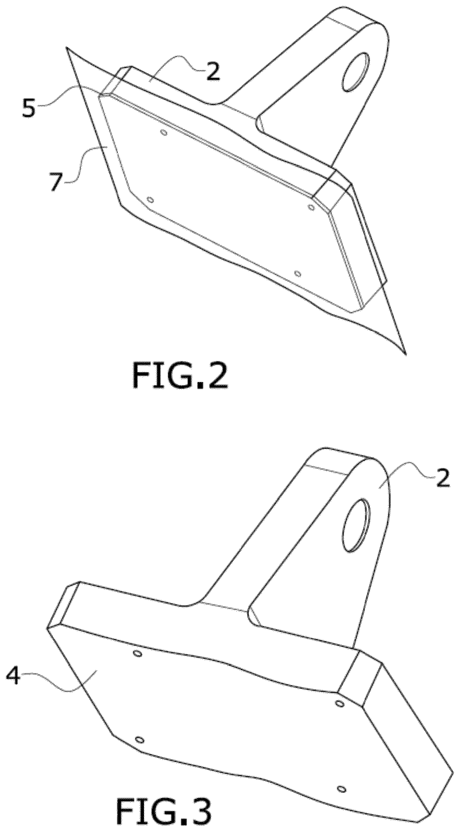

Figure 2 shows a perspective view of the intersection of a digitised receptor surface of the first aircraft structure and a CAD model of the second aircraft structure.
Figure 3 shows a perspective view of the CAD model of the second aircraft structure having a coupling surface obtained from the receptor surface.

### Detailed description of the invention

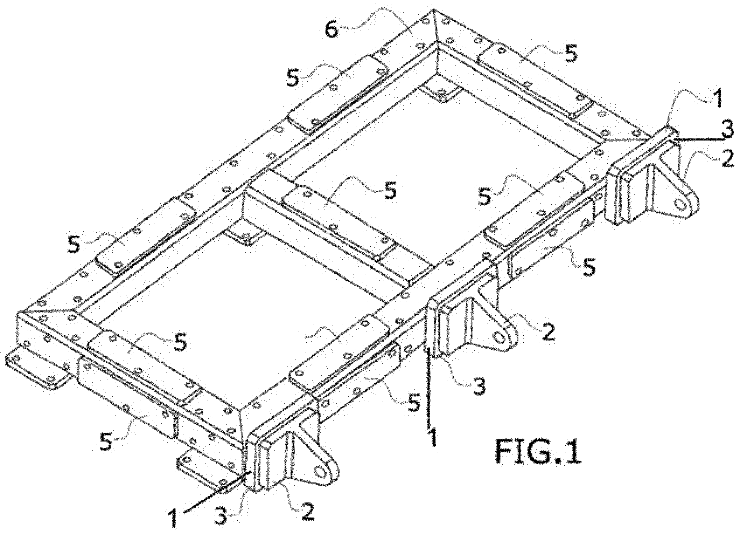

Figure 1 discloses an embodiment showing a first aircraft part (1) coupled to a support structure (6) comprising a set of reference elements (5), specifically a set of reference surfaces, and three receptor surfaces (3) of three second aircraft parts (2), specifically, three fittings adapted to be joined to the three receptor surfaces (3).

The reference elements (5) will be used to properly align the digitised receptor surface (3) with the computer designed model (CAD) of the first (1) and the second (2) aircraft parts. Therefore, the set of reference elements (5) collaborates in the proper alignment of the cloud of points with the CAD model. Another possibility, although less preferred, is to locate the referenced elements (5) directly on the first aircraft part (1). The advantage of locating the reference elements (5) on a support structure (6) of the first aircraft part (1) is that the aircraft part (1) does not need to be manipulated to locate or to remove the reference elements (5) and secondly that the same support structure (6) with its reference elements (5) can be used for the assembly of several aircraft parts (1, 2) of the same kind.

Therefore, a support structure (6) comprising the reference elements (5) would be advisable, i.e. an external support structure (6) that will be used to locate the reference elements (5). This support structure (6) requires some dimensional stability but not as restrictive as in the case of the jigs.

Thus, in an embodiment, the method comprises the following steps:
- providing a set of reference elements (5) coupled with the first aircraft part (1),
- providing a computer model of the first (1) and the second (2) aircraft parts comprising said set of reference elements (5),
- digitalising by a digitalising system the set of reference elements (5),
- aligning the digitalised reference elements (5) with the computer model of the first (1) and the second (2) aircraft parts.

Once the reference elements (5) are established and digitised, the next step is to generate a cloud of points that will serve as the basis for the subsequent obtaining of the desired surfaces. In this digitalisation, information has been obtained from both the receptor surface (3) and the set of reference elements (5) that could be used for the alignment.

As previously stated, once the results of the digitalising process are obtained, they must be aligned with the CAD model. The correctness of this alignment process is important for achieving an accurate result, and requires the proper choice of alignment reference elements (5). In this sense, it is advisable that the reference elements (5) used in the alignment process is distributed evenly throughout the first aircraft structure (1) or throughout the support structure (6), whichever is the case.

Once the cloud of points obtained in the digitalisation process has been processed, said cloud of points will be exported in the appropriate format, for instance .asc, to the chosen modeling software, i.e., CATIA. It is important to point out at this point a set of considerations that is advisable to be taken into account:
1. The more uniform the distribution of the points generated in the cloud of points, the better is the generated surface.
2. Having previously aligned all elements of the set measured, the situation of these with respect to the CAD model will be correct.

Once the cloud of points is available, the next step would be, optionally, setting the parameters for creating a mathematical function (7) of the receptor surface (3), therefore a mathematical function (7) is extracted from the cloud of points of the receptor surface (3) using software.

With a mathematical function (7) of the receptor surface (3) generated from the cloud of points, and given that it has the appropriate location to intersect the theoretical CAD model of the second aircraft part (2), the final model of the second aircraft part (2) for manufacturing will be generated. Thus, a simple trimming operation will allow us to obtain the desired morphology with respect to the theoretical fitting of the embodiment.

As previously stated, the CAD model of the second aircraft part (2) comprises machining allowances for its subsequent machining and adjustment on the receptor surface (3). It is important to keep in mind that as the fittings to be positioned comprises machining allowances, will appear interference between the receptor surfaces and said fittings. These interferences will be used for subsequently cut the length of the fittings.

Additionally, in an embodiment, to digitise the whole first aircraft part (1) a plurality of digitalisation steps are to be performed, thus the first aircraft part (1) being digitised in sections that are afterwards aligned. For instance, when shadows are created because of the shape of the first aircraft part (1) that make necessary to digitise the part (1) from different points of view or when the first aircraft part (1) is too large to be digitalised in only one step.

In order to properly align the different digitalization sections to form the whole first aircraft part (1), alignment targets are located on the support structure (6) or on the first aircraft part (1). As previously explained for the reference elements (5) it is preferred to locate the target elements on the support structure (6) for the same reasons stated above.

In an embodiment, the alignment targets are small stickers that are located on the surface of the support structure (6). Using optical methods, like photogrammetry, it can be obtained with high accuracy the relative position of the alignment targets, said alignment targets defining a photogrammetric skeleton of the support structure (6). The positions will be used to assembly the different clouds of points obtained in the digitalisation process. The photogrammetry skeleton is simply used to refer or overlap the different shots that are made of the aeronautical element, and above all to reduce measurement errors.

Using a high resolution digitalisation system, the receptor surface (3) will be digitised, automatically aligning the digitised surface (3) with the photogrammetry skeleton of the support structure (6) due to target recognition. Therefore, the following steps are performed:
- providing a set of alignment targets coupled with the first aircraft part (1),
- defining a photogrammetric skeleton of the alignment targets coupled to the first aircraft part (1),
- providing a computer model of the first (1) and the second (2) aircraft parts comprising said set of alignment targets,
- digitalising by a digitalising system the set of alignment targets,
- aligning the photogrammetry skeleton with the program model of the first aircraft part (1),
- digitalising the receptor surface (3).

More specifically in an embodiment, the following steps are performed:
- Placing a set of target elements, for instance, stickers, in different sections of the support structure (6) of the first aircraft part (1) that will serve as reference points of the different shots to perform.
- Produce a photogrammetry skeleton from the set of target elements.
- Aligning the photogrammetry skeleton comprising the target elements with the CAD model of the first aircraft part (1),
- Digitalising the receptor zones (3) by means of the high resolution digitalisation system.

## Claims

1. Manufacturing and assembly method of parts of an aircraft comprising the following steps:
- providing a first aircraft part (1) comprising at least a receptor surface (3) on which a coupling surface (4) of a second aircraft part (2) is to be assembled,
- providing in a computer program a model of the first (1) and the second (2) aircraft parts located in its assembled position, the model of the second (2) aircraft part comprising machining allowances (5) in its coupling surface (4),
- digitalising by a digitalising system the receptor surface (3) of the first aircraft part (1) obtaining a digitalised surface,
the method being **characterised in that** it further comprises the steps of:
- positioning the digitalisation of the receptor surface (3) in the computer model of the first (1) and the second (2) aircraft parts in the assembled position such that the digitalisation of the receptor surface (3) intersects the machining allowances (5) of the coupling surface (4) of the second (2) aircraft part,
- obtaining in the computer model a computer designed model of the second part (2) in which the coupling surface (4) of the second aircraft part (2) adapted to be assembled on the receptor surface (3) of the first aircraft part (1) fits to the digitalised receptor surface (3),
- mechanising the second aircraft part (2) to be assembled from the above obtained computer model,
- assembling the mechanised second aircraft part (2) to the provided first aircraft part (1).

2. Manufacturing and assembly method of parts of an aircraft, according to claim 1, wherein it comprises the following steps:
- providing a set of reference elements (5) coupled with the first aircraft part (1),
- providing a computer model of the first (1) and the second (2) aircraft parts comprising said set of reference elements (5),
- digitalising by a digitalising system the set of reference elements (5),
- aligning the digitalised reference elements (5) with the computer model of the first (1) and the second (2) aircraft parts.

3. Manufacturing and assembly method of parts of an aircraft, according to claim 2, wherein it comprises the step of providing the first aircraft part (1) over a supporting structure (6), said supporting structure (6) comprising the reference elements (5).

4. Manufacturing and assembly method of parts of an aircraft, according to any preceding claim, wherein the digitalised surface of the receptor surface (3) of the first aircraft part (1) is formed by a cloud of points and the method further comprises the step of obtaining a mathematical function (7) from the cloud of points by a computerised processing system.

5. Manufacturing and assembly method of parts of an aircraft, according to any preceding claim, wherein the digitalisation of the first aircraft part (1) is performed in steps of different sections of the first aircraft part (1) that are afterwards aligned to form the whole aircraft part (1).

6. Manufacturing and assembly method of parts of an aircraft, according to claim 5, wherein it comprises the following steps:
- providing a set of alignment targets coupled with the first aircraft part (1),
- defining a photogrammetric skeleton of the alignment targets coupled to the first aircraft part (1),
- providing a computer model of the first (1) and the second (2) aircraft parts comprising said set of alignment targets,
- digitalising by a digitalising system the set of alignment targets,
- aligning the photogrammetry skeleton with the program model of the first aircraft part (1),
- digitalising the receptor surface (3).

7. Manufacturing and assembly system of parts of an aircraft, comprising:
- a computer program model of the first (1) and the second (2) aircraft parts configured to be located in its assembled positions, the first aircraft part (1) configured to have at least a receptor surface (3) on which a coupling surface (4) of the second aircraft part (2) is to be assembled and the model of the second aircraft part (2) comprising machining allowances in its coupling surface,
- a digitalising system configured to digitalise the receptor surface (3) of the first aircraft part (1),
**characterised in that**:
∘ the computer program model being configured to position the digitalisation of the receptor surface (3) in the assembled position such that the digitalisation of the receptor surface (3) intersects the machining allowances (5) of the coupling surface (4) of the second (2) aircraft part,
∘ the computer program model being also configured to obtain a computer designed model of the second part (2) in which the coupling surface (4) of the second part (2) adapted to be assembled on the receptor surface (3) of the first part (1) is configured to fit the digitalised receptor surface (3),
and **characterised in that** the system further comprises a mechanising system configured to mechanise the obtained computer designed model of the second part (2).

8. Manufacturing and assembly system of parts of an aircraft, according to claim 6, wherein the first aircraft part (1) and the computer model of the first (1) and the second (2) aircraft parts comprise a set of reference elements (5) configured to align the digitalised reference elements (5) with the computer model of the first (1) and the second (2) aircraft parts.

9. Manufacturing and assembly system of parts of an aircraft, according to claim 8, wherein it comprises a supporting structure (6) of the first aircraft part (1), said supporting structure (6) comprising the reference elements (5).

10. Manufacturing and assembly system of parts of an aircraft, according to any preceding claim 7 to 9, wherein the digitalising system is configured to obtained a cloud of points of the digitalization of the receptor surface (3) of the first aircraft part (1) and the manufacturing and assembly system comprises a processing system configured to define a mathematical function for the receptor surface (3) from the cloud of points and to obtain a computer designed model of the second part (2) in which the surface of the second part (2) adapted to be assembled on the receptor surface (3) of the first aircraft part (1) adapts to the mathematical receptor surface (3).

11. Manufacturing and assembly system of parts of an aircraft, according to any preceding claim 7 to 10, wherein it comprises:
- a set of alignment targets coupled with the first aircraft part (1),
- a photogrametry system configured to digitalise the alignment targets and to define a photogrammetric skeleton of said alignment targets,
- the computer model of the first (1) and the second (2) aircraft parts comprising said set of alignment targets,
- the digitalizing system configured to digitalise the set of alignment targets,
- the computer model configured to the photogrammetry skeleton with the program model of the first aircraft part (1),

## Patentansprüche

1. Herstellungs- und Montageverfahren von Teilen eines Flugzeugs, umfassend die folgenden Schritte:
- Bereitstellen eines ersten Flugzeugteils (1), das mindestens eine Aufnahmefläche (3) umfasst, auf der eine Verbindungsfläche (4) eines zweiten Flugzeugteils (2) zu montieren ist,
- Bereitstellen eines Modells des ersten (1) und des zweiten (2) Flugzeugteils in der montierten Position in einem Computerprogramm, wobei das Modell des zweiten (2) Flugzeugteils Bearbeitungszugaben (5) in der Verbindungsfläche (4) umfasst,
- Digitalisieren der Aufnahmefläche (3) des ersten Flugzeugteils (1) durch ein Digitalisierungssystem, um eine digitalisierte Oberfläche zu erhalten, wobei das Verfahren **dadurch gekennzeichnet ist, dass** es ferner die folgenden Schritte umfasst:
- Positionieren der Digitalisierung der Aufnahmefläche (3) im Computermodell des ersten (1) und des zweiten (2) Flugzeugteils in der montierten Position so, dass die Digitalisierung der Aufnahmefläche (3) die Bearbeitungszugaben (5) der Verbindungsfläche (4) des zweiten (2) Flugzeugteils schneidet,
- Erhalten eines computerkonstruierten Modells des zweiten Teils (2) im Computermodell, in dem die Verbindungsfläche (4) des zweiten Flugzeugteils (2), die dazu angepasst ist, auf die Aufnahmefläche (3) des ersten Flugzeugteils (1) montiert zu werden, zur digitalisierten Aufnahmefläche (3) passt,
- Mechanisieren des zweiten Flugzeugteils (2), das anhand des oben erhaltenen Computermodells zu montieren ist,
- Montieren des mechanisierten zweiten Flugzeugteils (2) an das bereitgestellte erste Flugzeugteil (1).

2. Herstellungs- und Montageverfahren von Teilen eines Flugzeugs gemäß Anspruch 1, wobei es die folgenden Schritte umfasst:
- Bereitstellen eines Satzes von Referenzelementen (5), die mit dem ersten Flugzeugteil (1) verbunden sind,
- Bereitstellen eines Computermodells des ersten (1) und des zweiten (2) Flugzeugteils, das den Satz von Referenzelementen (5) umfasst,
- Digitalisieren des Satzes von Referenzelementen (5) durch ein Digitalisierungssystem,
- Abgleichen der digitalisierten Referenzelemente (5) mit dem Computermodell des ersten (1) und des zweiten (2) Flugzeugteils.

3. Herstellungs- und Montageverfahren von Teilen eines Flugzeugs gemäß Anspruch 2, wobei das erste Flugzeugteil (1) über einer Tragstruktur (6) bereitgestellt wird, wobei die Tragstruktur (6) die Referenzelemente (5) umfasst.

4. Herstellungs- und Montageverfahren von Teilen eines Flugzeugs gemäß einem der vorhergehenden Ansprüche, wobei die digitalisierte Oberfläche der Aufnahmefläche (3) des ersten Flugzeugteils (1) durch eine Punktwolke gebildet wird und das Verfahren ferner den Schritt des Erhaltens einer mathematischen Funktion (7) aus der Punktwolke durch ein computerisiertes Verarbeitungssystem umfasst.

5. Herstellungs- und Montageverfahren von Teilen eines Flugzeugs gemäß einem der vorhergehenden Ansprüche, wobei die Digitalisierung des ersten Flugzeugteils (1) in Schritten verschiedener Abschnitte des ersten Flugzeugteils (1) erfolgt, die anschließend zur Bildung des gesamten Flugzeugteils (1) abgeglichen werden.

6. Herstellungs- und Montageverfahren von Teilen eines Flugzeugs gemäß Anspruch 5, wobei es die folgenden Schritte umfasst:
- Bereitstellen eines Satzes von Abgleichzielen, die mit dem ersten Flugzeugteil (1) verbunden sind,
- Definieren eines photogrammetrischen Skeletts der mit dem ersten Flugzeugteil (1) verbundenen Abgleichziele,
- Bereitstellen eines Computermodells des ersten (1) und des zweiten (2) Flugzeugteils, die den Satz von Abgleichzielen umfassen,
- Digitalisieren des Satzes von Abgleichzielen durch ein Digitalisierungssystem,
- Abgleichen des photogrammetrischen Skeletts mit dem Programmmodell des ersten Flugzeugteils (1),
- Digitalisieren der Aufnahmefläche (3).

7. Herstellungs- und Montagesystem von Teilen eines Flugzeugs, umfassend:
- ein Computerprogrammmodell des ersten (1) und des zweiten (2) Flugzeugteils, das dazu ausgelegt ist, sich in den montierten Positionen zu befinden, wobei das erste Flugzeugteil (1) so ausgelegt ist, dass es mindestens eine Aufnahmefläche (3) aufweist, auf der eine Verbindungsfläche (4) des zweiten Flugzeugteils (2) zu montieren ist, und wobei das Modell des zweiten Flugzeugteils (2) Bearbeitungszugaben in der Verbindungsfläche umfasst,
- ein Digitalisierungssystem, das zum Digitalisieren der Aufnahmefläche (3) des ersten Flugzeugteils (1) ausgelegt ist, **dadurch gekennzeichnet, dass**:
o das Computerprogrammmodell dazu ausgelegt ist, die Digitalisierung der Aufnahmefläche (3) in der montierten Position so zu positionieren, dass die Digitalisierung der Aufnahmefläche (3) die Bearbeitungszugaben (5) der Verbindungsfläche (4) des zweiten (2) Flugzeugteils schneidet,
o wobei das Computerprogrammmodell außerdem dazu ausgelegt ist, ein computerkonstruiertes Modell des zweiten Teils (2) zu erhalten, bei dem die Verbindungsfläche (4) des zweiten Teils (2), die zum Montieren auf der Aufnahmefläche (3) des ersten Teils (1) angepasst ist, dazu ausgelegt ist, auf die digitalisierte Aufnahmefläche (3) zu passen,
und **dadurch gekennzeichnet, dass** das System ferner umfasst:
- ein Mechanisierungssystem, das zum Mechanisieren des erhaltenen computerkonstruierten Modells des zweiten Teils (2) ausgelegt ist.

8. Herstellungs- und Montagesystem von Teilen eines Flugzeugs gemäß Anspruch 6, wobei das erste Flugzeugteil (1) und das Computermodell des ersten (1) und des zweiten (2) Flugzeugteils einen Satz von Referenzelementen (5) umfassen, die dazu ausgelegt sind, die digitalisierten Referenzelemente (5) mit dem Computermodell des ersten (1) und des zweiten (2) Flugzeugteils auszurichten.

9. Herstellungs- und Montagesystem von Teilen eines Flugzeugs gemäß Anspruch 8, wobei es eine Tragstruktur (6) des ersten Flugzeugteils (1) umfasst, wobei die Tragstruktur (6) die Referenzelemente (5) umfasst.

10. Herstellungs- und Montagesystem von Teilen eines Flugzeugs gemäß einem der vorhergehenden Ansprüche 7 bis 9, wobei das Digitalisierungssystem zum Erhalten einer Punktwolke der Digitalisierung der Aufnahmefläche (3) des ersten Flugzeugteils (1) ausgelegt ist, und das Herstellungs- und Montagesystem ein Verarbeitungssystem umfasst, das zum Definieren einer mathematischen Funktion für die Aufnahmefläche (3) aus der Punktwolke und zum Erhalten eines computerkonstruierten Modells des zweiten Teils (2) ausgelegt ist, bei dem sich die Oberfläche des zweiten Teils (2), die auf die Aufnahmefläche (3) des ersten Flugzeugteils (1) zu montieren ist, an die mathematische Aufnahmefläche (3) anpasst.

11. Herstellungs- und Montagesystem für Teile eines Flugzeugs gemäß einem der vorhergehenden Ansprüche 7 bis 10, wobei es umfasst:
- einen Satz von Abgleichzielen, die mit dem ersten Flugzeugteil (1) gekoppelt sind,
- ein Photogrammetriesystem, das dazu ausgelegt ist, die Abgleichziele zu digitalisieren und ein photogrammetrisches Skelett der Abgleichziele zu definieren,
- das Computermodell des ersten (1) und des zweiten (2) Flugzeugteils, die den Satz von Abgleichzielen umfassen,
- das Digitalisierungssystem, das dazu ausgelegt ist, den Satz von Abgleichzielen zu digitalisieren,
- das Computermodell, das dazu ausgelegt ist, das Photogrammetrieskeletts mit dem Programmmodell des ersten Flugzeugteils (1) zu.

## Revendications

1. Procédé de fabrication et d'assemblage de parties d'un aéronef comprenant les étapes suivantes :
- la fourniture d'une première partie d'aéronef (1) comprenant au moins une surface réceptrice (3) sur laquelle une surface de couplage (4) d'une seconde partie d'aéronef (2) est destinée à être assemblée,
- la fourniture dans un programme informatique d'un modèle des première (1) et seconde (2) parties d'aéronef situées dans leur position assemblée, le modèle de la seconde (2) partie d'aéronef comprenant des surépaisseurs d'usinage (5) dans sa surface de couplage (4),
- la numérisation par un système de numérisation de la surface réceptrice (3) de la première partie d'aéronef (1) pour obtenir une surface numérisée,
le procédé étant **caractérisé en ce qu'**il comprend en outre les étapes :
- de positionnement de la numérisation de la surface réceptrice (3) dans le modèle informatique des première (1) et seconde (2) parties d'aéronef dans la position assemblée de telle sorte que la numérisation de la surface réceptrice (3) croise les surépaisseurs d'usinage (5) de la surface de couplage (4) de la seconde (2) partie d'aéronef,
- d'obtention dans le modèle informatique d'un modèle conçu par ordinateur de la seconde partie (2) dans lequel la surface de couplage (4) de la seconde partie d'aéronef (2) adaptée pour être assemblée sur la surface réceptrice (3) de la première partie d'aéronef (1) s'ajuste à la surface réceptrice numérisée (3),
- de mécanisation de la seconde partie d'aéronef (2) destinée à être assemblée à partir du modèle informatique obtenu ci-dessus,
- d'assemblage de la seconde partie d'aéronef (2) mécanisée à la première partie d'aéronef (1) fournie.

2. Procédé de fabrication et d'assemblage de parties d'un aéronef selon la revendication 1, dans lequel il comprend les étapes suivantes :
- la fourniture d'un ensemble d'éléments de référence (5) couplés à la première partie d'aéronef (1),
- la fourniture d'un modèle informatique des première (1) et seconde (2) parties d'aéronef comprenant ledit ensemble d'éléments de référence (5),
- la numérisation par un système de numérisation de l'ensemble d'éléments de référence (5),
- l'alignement des éléments de référence (5) numérisés avec le modèle informatique des première (1) et seconde (2) parties d'aéronef.

3. Procédé de fabrication et d'assemblage de parties d'un aéronef selon la revendication 2, dans lequel il comprend l'étape de fourniture de la première partie d'aéronef (1) sur une structure de support (6), ladite structure de support (6) comprenant les éléments de référence (5).

4. Procédé de fabrication et d'assemblage de parties d'un aéronef selon l'une quelconque des revendications précédentes, dans lequel la surface numérisée de la surface réceptrice (3) de la première partie d'aéronef (1) est formée par un nuage de points et le procédé comprend en outre l'étape d'obtention d'une fonction mathématique (7) à partir du nuage de points par un système de traitement informatisé.

5. Procédé de fabrication et d'assemblage de parties d'un aéronef selon l'une quelconque des revendications précédentes, dans lequel la numérisation de la première partie d'aéronef (1) est effectuée en étapes de différentes sections de la première partie d'aéronef (1) qui sont ensuite alignées pour former l'ensemble de la partie d'aéronef (1).

6. Procédé de fabrication et d'assemblage de parties d'un aéronef selon la revendication 5, dans lequel il comprend les étapes suivantes :
- la fourniture d'un ensemble de cibles d'alignement couplées à la première partie d'aéronef (1),
- la définition d'un squelette photogrammétrique des cibles d'alignement couplées à la première partie d'aéronef (1),
- la fourniture d'un modèle informatique des première (1) et seconde (2) parties d'aéronef comprenant ledit ensemble de cibles d'alignement,
- la numérisation par un système de numérisation de l'ensemble de cibles d'alignement,
- l'alignement du squelette photogrammétrique avec le modèle de programme de la première partie d'aéronef (1),
- la numérisation de la surface réceptrice (3).

7. Système de fabrication et d'assemblage de parties d'un aéronef, comprenant :
- un modèle de programme informatique des première (1) et seconde (2) parties d'aéronef configurées pour être situées dans leur position assemblée, la première partie d'aéronef (1) configurée pour avoir au moins une surface réceptrice (3) sur laquelle une surface de couplage (4) de la seconde partie d'aéronef (2) est destinée à être assemblée et le modèle de la seconde partie d'aéronef (2) comprenant des surépaisseurs d'usinage dans sa surface de couplage,
- un système de numérisation configuré pour numériser la surface réceptrice (3) de la première partie d'aéronef (1),
**caractérisé en ce que** :
• le modèle de programme informatique étant configuré pour positionner la numérisation de la surface réceptrice (3) dans la position assemblée de telle sorte que la numérisation de la surface réceptrice (3) croise les surépaisseurs d'usinage (5) de la surface de couplage (4) de la seconde (2) partie d'aéronef,
• le modèle de programme informatique étant également configuré pour obtenir un modèle conçu par ordinateur de la seconde partie (2) dans lequel la surface de couplage (4) de la seconde partie (2) adaptée pour être assemblée sur la surface réceptrice (3) de la première partie (1) est configurée pour s'ajuster avec la surface réceptrice (3) numérisée,
et **caractérisé en ce que** le système comprend en outre un système de mécanisation configuré pour mécaniser le modèle conçu par ordinateur de la seconde partie (2) obtenu.

8. Système de fabrication et d'assemblage de parties d'un aéronef selon la revendication 6, dans lequel la première partie d'aéronef (1) et le modèle informatique des première (1) et seconde (2) parties d'aéronef comprennent un ensemble d'éléments de référence (5) configuré pour aligner les éléments de référence (5) numérisés avec le modèle informatique des première (1) et seconde (2) parties d'aéronef.

9. Système de fabrication et d'assemblage de parties d'un aéronef selon la revendication 8, dans lequel il comprend une structure de support (6) de la première partie d'aéronef (1), ladite structure de support (6) comprenant les éléments de référence (5).

10. Système de fabrication et d'assemblage de parties d'un aéronef selon l'une quelconque des revendications précédentes 7 à 9, dans lequel le système de numérisation est configuré pour obtenir un nuage de points de la numérisation de la surface réceptrice (3) de la première partie d'aéronef (1) et le système de fabrication et d'assemblage comprend un système de traitement configuré pour définir une fonction mathématique pour la surface réceptrice (3) à partir du nuage de points et pour obtenir un modèle conçu par ordinateur de la seconde partie (2) dans lequel la surface de la seconde partie (2) adaptée pour être assemblée sur la surface réceptrice (3) de la première partie d'aéronef (1) s'adapte à la surface réceptrice mathématique (3).

11. Système de fabrication et d'assemblage de parties d'un aéronef selon l'une quelconque des revendications précédentes 7 à 10, dans lequel il comprend :
- un ensemble de cibles d'alignement couplées à la première partie d'aéronef (1),
- un système photogrammétrique configuré pour numériser les cibles d'alignement et pour définir un squelette photogrammétrique desdites cibles d'alignement,
- le modèle informatique des première (1) et seconde (2) parties d'aéronef comprenant ledit ensemble de cibles d'alignement,
- le système de numérisation configuré pour numériser l'ensemble de cibles d'alignement,
- le modèle informatique configuré pour le squelette photogrammétrique avec le modèle de programme de la première partie d'aéronef (1).
